# EUROPÄISCHE PATENTSCHRIFT

(11) **EP 0 839 441 B1**
(45) Veröffentlichungstag und Bekanntmachung des Hinweises auf die Patenterteilung: **20.01.1999**
(21) Anmeldenummer: 96923952.4
(22) Anmeldetag: 27.06.1996
(51) Int. Cl.: H05K 9/00, H05K 7/20, B01D 46/10

(54) **HF-DICHT IN DEN DURCHBRUCH EINER MONTAGEPLATTE EINGEBAUTER FILTERLÜFTER**
FILTER VENTILATOR BUILT IN A HF-TIGHT MANNER INTO A SLOT OF A MOUNTING PLATE
VENTILATEUR DE FILTRAGE MONTE DE MANIERE ETANCHE AUX HAUTES FREQUENCES DANS UNE FENTE D'UNE PLAQUE DE MONTAGE

(30) Priorität: 15.07.1995 DE 19525850
(43) Veröffentlichungstag der Anmeldung: 06.05.1998
(73) Patentinhaber: Rittal-Werk Rudolf Loh GmbH & Co. KG, 35745 Herborn (DE)
(72) Erfinder: IMMEL, Manfred, D-35756 Mittenaar-Bicken (DE)
(74) Vertreter: Fleck, Hermann-Josef, Dr.-Ing.
(86) Internationale Anmeldenummer: EP9602807
(87) Internationale Veröffentlichungsnummer: WO9704630

(56) Entgegenhaltungen:
- EP-A- 0 162 960
- EP-A- 0 397 616
- EP-A- 0 425 326
- EP-A- 0 654 962
- DE-C- 4 312 664

## Beschreibung

Die Erfindung betrifft einen HF-dicht in den Durchbruch einer Montageplatte eingebauten Filterlüfter.

Aus EP-A-0 819 369, das zum Stand der Technik gemäß Artikel 54(3) gehört, ist ein HF-dicht in den Durchbruch einer Montageplatte eingebauter Filterlüfter bekannt. Das elektrisch leitfähige Gehäuse dieses Filterlüfters wird jedoch ohne Zwischenlage eines elektrisch leitfähigen Klebers mit der Montageplatte verbunden.

Bei dem Einbau eines Filterlüfters in den Durchbruch einer als Schaltschrankwand dienenden Montageplatte besteht in bestimmten Anwendungsfällen die Notwendigkeit, auch im Bereich des Filterlüfters eine eindeutige HF-Abdichtung zu erreichen. Dies ist insbesondere bei einem HF-dicht abgeschlossenen Schaltschrank erforderlich.

Es ist Aufgabe der Erfindung, bei einem einfachen Aufbau des Filterlüfters mit einem einfachen Einbau eine eindeutige HF-Abdichtung zu erreichen.

Diese Aufgabe wird dadurch gelöst, daß ein mit einem elektrisch leitfähigen Belag versehenes Gehäuse mit einem Aufnahmeteil durch den Durchbruch der Montageplatte ragt und mit einem Flansch unter Zwischenlage eines elektrisch leitenden Klebers um den Durchbruch mit der Montageplatte verbunden ist, daß unter Zwischenlage eines Drahtgitters ein Ventilator mit dem durch den Durchbruch ragenden Aufnahmeteil des Gehäuses verbunden ist und daß die in den Aufnahmeteil des Gehäuses eingebrachte Filtermatte mittels eines Lamellengitters abgedeckt ist.

Das elektrisch leitende Gehäuse und das elektrisch leitende Drahtgitter überdecken den Durchbruch der Montageplatte HF-dicht und die zwischen dem Flansch des Gehäuses und der Montageplatte eingebrachte Kleberschicht dichtet die Übergangsstelle zwischen dem Gehäuse und der Montageplatte HF-dicht ab, so daß ein absolut HF-dichter Einbau des Filterlüfters gewährleistet ist.

Der Einbau des Filterlüfters wird dadurch vereinfacht und erleichtert, daß vor dem Einsetzen des Gehäuses in den Durchbruch der Montageplatte in den zwischen Aufnahmeteil und Flansch des Gehäuses gebildeten Eckbereich eine umlaufende Schicht des Klebers aufgetragen wird.

Die Verbindung zwischen dem Gehäuse und der Montageplatte kann dadurch noch verbessert werden, daß der Flansch des Gehäuses mittels Schrauben zusätzlich mit der mit Schraubenaufnahmen versehenen Montageplatte verschraubt ist.

Ist nach einer Ausgestaltung vorgesehen, daß die dem Drahtgitter und dem Ventilator zugekehrte Seite des Aufnahmeteils des Gehäuses gitterförmig ausgebildet ist, dann kann die Filtermatte im Aufnahmeteil des Gehäuses abgestützt werden, ohne daß das Gehäuse den Luftdurchlaß unnötig erschwert.

Das Drahtgitter ist vorzugsweise feinmaschig ausgebildet und wird zusammen mit dem Ventilator am Aufnahmeteil des Gehäuses angebracht.

Der Einbau kann nach einem Verfahren dadurch erleichtert werden, daß Ventilator, Drahtgitter und Gehäuse eine vorgefertigte Einheit bilden, die mit der Schicht aus elektrisch leitfähigem Kleber versehen mit der Montageplatte verbunden wird, und daß danach die Filtermatte in das Gehäuse eingesetzt und mit dem Lamellengitter abgedeckt wird.

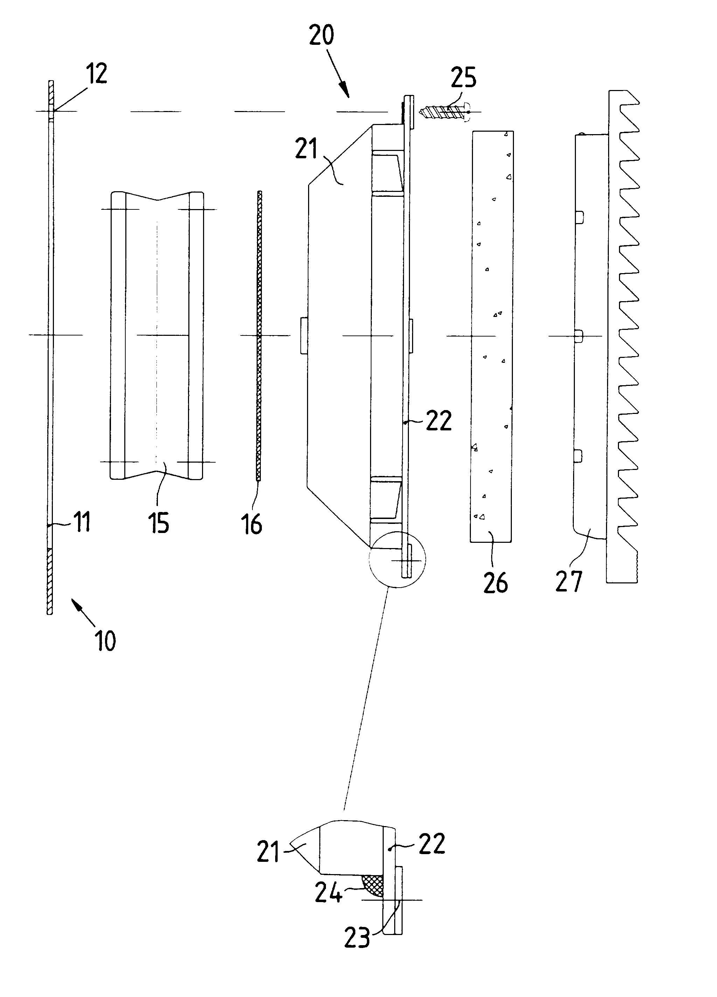

Die Erfindung wird anhand eines in der Zeichnung in Explosionsdarstellung wiedergegebenen Filterlüfters näher erläutert.

Die Montageplatte 10 der Zeichnung kann eine Schaltschrankwand sein und weist einen Durchbruch 11 auf. Um den Durchbruch 11 sind Schraubaufnahmen 12 eingebracht. Das wesentliche Teil des Filterlüfters ist das Gehäuse 20, das mit einem elektrisch leitenden Belag versehen ist. Das Gehäuse 20 kann aus Kunststoff bestehen und nachträglich mit dem elektrisch leitenden Belag beschichtet sein.

Das Gehäuse 20 weist ein Aufnahmeteil 21 und einen Flansch 22 mit Befestigungsbohrungen 23 auf. Das topfartige Aufnahmeteil 21 ist an den Durchbruch 11 angepaßt und wird vor dem Einbau mit einem Drahtgitter 16 und dem Ventilator 15 verbunden. Gehäuse 20, Drahtgitter 16 und Ventilator 15 können eine vorgefertigte Einheit bilden, die in den Durchbruch 11 der Montageplatte 10 eingesetzt werden kann. Vor dem Einsetzen wird in den zwischen Aufnahmeteil 21 und Flansch 22 des Gehäuses 20 gebildeten Eckbereich umlaufend eine Schicht eines elektrisch leitfähigen Klebers 24 aufgebracht. Mit Schrauben 25 wird die vorgefertigte Einheit mit der Montageplatte 10 verschraubt. Dabei wird der Kleber 24 verteilt und dichtet den Übergang zwischen der Montageplatte 10 und dem Flansch 22 des Gehäuses 20 HF-dicht ab.

In den Aufnahmeteil 21 des Gehäuses 20 wird die Filtermatte 26 eingesetzt und mittels eines Lamellengitters 27 abgedeckt. Der Filterlüfter ist absolut HF-dicht in den Durchbruch 11 der Montageplatte 10 eingebaut. Das Drahtgitter 16 ist feinmaschig ausgebildet. Die dem Drahtgitter 16 zugekehrte Seite des Aufnahmeteils 21 ist vorzugsweise gitterförmig ausgebildet und unterstützt die eingesetzte Filtermatte 26.

Die Teile des Filterlüfters sind einfach und der Einbau ist mit wenig Montageaufwand durchführbar.

## Patentansprüche

1. HF-dicht in den Durchbruch einer Montageplatte eingebauter Filterlüfter, wobei
ein elektrisch leitfähiges Gehäuse (20) mit einem Aufnahmeteil (21) für eine Filtermatte (26) durch den Durchbruch (11) der Montageplatte (10) ragt und mit einem Flansch (22) unter Zwischenlage eines elektrisch leitfähigen Klebers (24) um den Durchbruch (11) mit der Montageplatte (10) verbunden ist,
unter Zwischenlage eines Drahtgitters (16) ein Ventilator (15) mit dem durch den Durchbruch (11) ragenden Aufnahmeteil (21) des Gehäuses (20) verbunden ist, und
die in den Aufnahmeteil (21) des Gehäuses (20) eingebrachte Filtermatte (26) mittels eines Lamellengitters (27) abgedeckt ist.

2. Filterlüfter nach Anspruch 1,
dadurch gekennzeichnet,
daß vor dem Einsetzen des Gehäuses (20) in den Durchbruch (11) der Montageplatte (10) in den zwischen Aufnahmeteil (21) und Flansch (22) des Gehäuses (20) gebildeten Eckbereich eine umlaufende Schicht des Klebers (24) aufgetragen wird.

3. Filterlüfter nach Anspruch 1 oder 2,
dadurch gekennzeichnet,
daß der Flansch (22) des Gehäuses (20) mittels Schrauben (25) zusätzlich mit der mit Schraubenaufnahmen (12) versehenen Montageplatte (10) verschraubt ist.

4. Filterlüfter nach einem der Ansprüche 1 bis 3,
dadurch gekennzeichnet,
daß die dem Drahtgitter (16) und dem Ventilator (15) zugekehrte Seite des Aufnahmeteils (21) des Gehäuses (20) gitterförmig ausgebildet ist.

5. Filterlüfter nach einem der Ansprüche 1 bis 4,
dadurch gekennzeichnet,
daß das Drahtgitter (16) feinmaschig ausgebildet und zusammen mit dem Ventilator (15) an dem Aufnahmeteil (21) des Gehäuses (20) angebracht ist.

6. Filterlüfter nach einem der Ansprüche 1 bis 5,
dadurch gekennzeichnet,
daß Ventilator (15), Drahtgitter (16) und Gehäuse (20) eine vorgefertigte Einheit bilden, die mit der Schicht aus elektrisch leitfähigem Kleber (24) versehen mit der Montageplatte (10) verbunden wird, und
daß danach die Filtermatte (26) in das Gehäuse (20) eingesetzt und mit dem Lamellengitter (27) abgedeckt wird.

7. Filterlüfter nach einem der Ansprüche 1 bis 6,
dadurch gekennzeichnet,
daß das Gehäuse (20) aus Kunststoff besteht und mit einem elektrisch leitfähigen Belag beschichtet ist.

## Claims

1. Filter ventilator, which is incorporated in the opening of a mounting plate in an HF-tight manner, wherein
- an electrically conductive housing (20), provided with a receiving member (21) for a filter mat (26), protrudes through the opening (11) of the mounting plate (10) and is connected to the mounting plate (10) by a flange (22) with the interposition of an electrically conductive adhesive (24) around the opening (11),
- a fan (15) is connected to the receiving member (21) of the housing (20) with the interposition of a wire mesh (16), said receiving member protruding through the opening (11), and
- the filter mat (26), introduced into the receiving member (21) of the housing (20), is covered by means of a laminar lattice (27).

2. Filter ventilator according to claim 1, characterised in that, prior to the insertion of the housing (20) in the opening (11) of the mounting plate (10), a circumferential layer of the adhesive (24) is applied in the corner region formed between receiving member (21) and flange (22) of the housing (20).

3. Filter ventilator according to claim 1 or 2, characterised in that the flange (22) of the housing (20) is additionally screw-connected to the mounting plate (10), which is provided with screw receivers (12), by means of screws (25).

4. Filter ventilator according to one of claims 1 to 3, characterised in that the side of the receiving member (21) of the housing (20) facing the wire mesh (16) and the fan (15) is configured in a lattice-like manner.

5. Filter ventilator according to one of claims 1 to 4, characterised in that the wire mesh (16) has a fine-meshed configuration and, together with the fan (15), is mounted on the receiving member (21) of the housing (20).

6. Filter ventilator according to one of claims 1 to 5, characterised in that fan (15), wire mesh (16) and housing (20) form a prefabricated unit which is connected to the mounting plate (10) by the layer of electrically conductive adhesive (24), and in that thereafter the filter mat (26) is inserted in the housing (20) and covered with the laminar lattice (27).

7. Filter ventilator according to one of claims 1 to 6, characterised in that the housing (20) is formed from plastics material and coated with an electrically conductive covering.

## Revendications

1. Ventilateur de filtrage monté de manière étanche aux hautes fréquences dans une fente d'une plaque de montage,
caractérisé
en ce qu'un boîtier à conductivité électrique (20) comportant un élément de réception (21) pour une natte de filtrage (26) passe au travers la fente (11) de la plaque de montage (10) et est par l'intermédiaire d'une bride (22), avec interposition d'une colle conductrice d'électricité (24), appliquée autour de la fente (11), relié à la plaque de montage (10),
en ce qu'avec interposition d'une grille métallique (16), un ventilateur (15) est relié à l'élément de réception (21) passant au travers de la fente (11) du boîtier (20), et
en ce que la natte de filtrage (26) introduite dans l'élément de réception (21) du boîtier (20) est recouverte d'une grille à lamelles (27).

2. Ventilateur de filtrage suivant la revendication 1,
caractérisé
en ce qu'avant la mise en place du boîtier (20) dans la fente (11) de la plaque de montage (10), une couche périphérique de la colle (24) est appliquée sur la zone d'angle formée entre l'élément de réception (21) et la bride (22) du boîtier.

3. Ventilateur de filtrage suivant la revendication 1 ou 2,
caractérisé en ce qu'en addition, la bride (22) du boîtier (20) est au moyen de vis (25) vissée sur la plaque de montage (10) présentant des forures de réception pour les vis.

4. Ventilateur de filtrage suivant l'une quelconque des revendications 1 à 3,
caractérisé en ce que la face de l'élément de réception (21) orientée vers la grille métallique (16) et vers le ventilateur (15) du boîtier (20) est en forme de grille.

5. Ventilateur de filtrage suivant l'une quelconque des revendications 1 à 4,
caractérisé en ce que la grille métallique (16) est à fines mailles et est conjointement avec le ventilateur (15) fixé à l'élément de réception (21) du boîtier (20).

6. Ventilateur de filtrage suivant l'une quelconque des revendications 1 à 5,
caractérisé
en ce que le ventilateur (15), la grille métallique (26) et le boîtier (20) constituent une unité préfabriquée, laquelle dotée d'une couche d'une colle à conductivité électrique (24) est reliée à la plaque de montage (10), et
en ce qu'ensuite la natte de filtrage (26) est mise en place dans le boîtier (20) et est recouverte de la grille à lamelles (27).

7. Ventilateur de filtrage suivant l'une quelconque des revendications 1 à 6,
caractérisé
en ce que le boîtier (20) est en matière plastique et est revêtu d'un revêtement à conductivité électrique.
